# EUROPEAN PATENT SPECIFICATION

(11) **EP 3 814 785 B1**
(45) Date of publication and mention of the grant of the patent: **27.09.2023**
(21) Application number: 19745723.7
(22) Date of filing: 26.06.2019
(51) Int. Cl.: G01R 19/25

(54) **METHODS AND APPARATUS FOR MAKING A TIME-SYNCHRONISED PHASOR MEASUREMENT**
VERFAHREN UND VORRICHTUNG ZUM VORNEHMEN EINER ZEITSYNCHRONISIERTEN PHASORMESSUNG
PROCÉDÉS ET APPAREIL DE RÉALISATION D'UNE MESURE DE PHASEUR À SYNCHRONISATION TEMPORELLE

(30) Priority: 28.06.2018 GB 201810680; 23.05.2019 GB 201907307
(43) Date of publication of application: 05.05.2021
(60) Divisional application: 23190697.5
(73) Proprietor: Synaptec Limited, Glasgow, Scotland G2 8AS (GB)
(72) Inventor: ORR, Philip, Glasgow G2 7JL (GB); NIEWCZAS, Pawel, Glasgow G2 7JL (GB); GORDON, Neil, Glasgow G2 7JL (GB)
(74) Representative: Lincoln IP
(86) International application number: PCT/GB2019/051806
(87) International publication number: WO 2020/002913

(56) References cited:
- US-A1- 2008 124 020
- QIN LIJUN ET AL: "Feasibility study of PMU based on IEEE 1588", ELECTRIC UTILITY DEREGULATION AND RESTRUCTURING AND POWER TECHNOLOGIES (DRPT), 2011 4TH INTERNATIONAL CONFERENCE ON, IEEE, 6 July 2011 (2011-07-06), pages 922-925, XP032039261, DOI: 10.1109/DRPT.2011.5994025 ISBN: 978-1-4577-0364-5
- ORR PHILIP ET AL: "Distributed photonic instrumentation for smart grids", 2013 IEEE INTERNATIONAL WORKSHOP ON APPLIED MEASUREMENTS FOR POWER SYSTEMS (AMPS), IEEE, 25 September 2013 (2013-09-25), pages 63-67, XP032553102, DOI: 10.1109/AMPS.2013.6656227 [retrieved on 2013-11-05]
- ORR P ET AL: "High-Speed, Solid State, Interferometric Interrogator and Multiplexer for Fiber Bragg Grating Sensors", JOURNAL OF LIGHTWAVE TECHNOLOGY, IEEE, USA, vol. 29, no. 22, 1 November 2011 (2011-11-01), pages 3387-3392, XP011391686, ISSN: 0733-8724, DOI: 10.1109/JLT.2011.2169044
- Nipendra Kayastha ET AL: "Smart grid sensor data collection, communication, and networking: a tutorial", Wireless Communications and Mobile Computing, 23 July 2012 (2012-07-23), pages 1055-1087, XP055576497, Oxford DOI: 10.1002/wcm.2258 Retrieved from the Internet: URL:https://onlinelibrary.wiley.com/doi/fu ll/10.1002/wcm.2258 [retrieved on 2019-04-02]

## Description

The present invention relates to the field of power transmission and distribution. More specifically, the present invention concerns improvements to arrangements which enable time-synchronised phasors (synchrophasors) to be determined from, enable time-stamping of signals and/or measurements from, and enable control signals to be delivered to, remote locations in a power network. In embodiments of the invention remote sensing modules are employed but the determination of synchrophasors and/or the time-stamping of signal received from the remote sensing modules is centralised, and in other embodiments of the invention control signals are delivered to remote control modules from a central location. In each case the invention benefits from the optical fibre typically present in power cables and enables additional functionality without the need for significant investment in equipment and infrastructure.

### Background to the invention

Synchronised electrical phasor measurements, termed synchrophasors, are used by electricity network or system operators to gauge critical information about the state of a power network, often over a large geographic area. A phasor is a vector quantity comprising the amplitude and phase of an AC electrical signal - typically voltage or current. Synchrophasors are phasors with the addition of a time-stamp which represents the precise time at which the measurement was made, generally to an absolute accuracy of within one microsecond. This time stamp is typically derived from the time broadcast on the GPS satellite network.

Having time-stamped phasors allows direct comparison of electrical quantities such as phase, frequency, amplitude, and power flows over long distances or broad geographic areas of a national or international power network, which enables a variety of power system analyses which are not discussed here (but see for example "Real-Time Application of Synchrophasors for Improving Reliability", October 2010, North American Electric Reliability Corporation, accessible at https://www.smartgrid.gov/files/rapir_final_10_17_10.pdf, and in particular Chapter 4 "Phasor Data Applications and Grid Reliability"). These analytics applications are of interest to both transmission and distribution system operators globally.

Traditionally, synchrophasors are calculated at or near the measurement location by a Phasor Measurement Unit (PMU), which is simply an electronic measurement system that takes inputs from nearby sensors and a GPS clock to produce an output comprising time-stamped phasors. Each PMU requires a power supply, access to the GPS network for an absolute time reference, and a traditional telecommunications network to transmit the calculated phasors from the measurement location. For these reasons, the cost of implementing a network of PMUs is prohibitive to many operators. The US Dept. of Energy estimates that while PMUs can cost $10k-15k per unit, the overall cost of a PMU network can be ten times the cost of the PMUs due to the extensive supporting infrastructure that is required.

This is typically the approach taken when time-stamping any signal or measurement. Accordingly, time-stamping of signals or measurements derived from such signals (for example voltage and/or current) also relies upon an extensive supporting infrastructure

A reliance on power supplies further restricts measurement locations to those where power is available, e.g. in transmission substations. The limited availability of measurement locations is insufficient for meaningful monitoring of transmission and distribution systems, but the alternative, i.e. installing power supplies in remote locations, is too costly.

Further, conventional PMU systems provide one-way measurements only. They do not provide a means for controlling local energy resources such as energy storage devices or generators. A desire to control local devices near the PMU is the natural extension of synchrophasor analysis (or analysis of other measurements), yet today additional control equipment (as well as telecommunications capabilities) would be required to enable this function, thus further increasing expense and complicating the infrastructure.

"Distributed photonic instrumentation for smart grids", Orr et al, 2013 IEEE International Workshop on Applied Measurements for Power Systems (AMPS), IEEE, 25 September 2013, pp 63-67, discloses a method of making a time-synchronised phasor measurement using optical transducers without the requirement for absolute time-stamping. In "Feasibility study of PMU based on IEEE 1588", Qin et al, Electric Utility Deregulation and Restructuring and Power Technologies (DRPT). 2011 4th International Conference on, IEEE, 6 July 2011, pp 922-925, instead of using the time broadcast on the GPS network, the authors use the precision-time protocol (PTP) "which defines the best clock as the master clock and generates a master-slave relationship among the clocks in the system".

Accordingly, it is an object of at least one aspect of the present invention to obviate and/or mitigate one or more disadvantages of known/prior arrangements, and in particular the reliance on extensive supporting infrastructure such as power supplies, GPS and telecommunications equipment.

Further aims and objects of the invention will become apparent from reading the following description.

### Summary of the invention

The invention is set out in the appended claims.

According to a first aspect of the invention, there is provided a method of making a time-synchronised phasor measurement comprising:
receiving, at an interrogator, an optical signal from a voltage and/or current sensor via an optical fibre
receiving, at the interrogator, a time synchronisation signal;
determining, at the interrogator, a time t at which the optical signal was received from the voltage and/or current sensor;
determining, at the interrogator, a time delay to corresponding to the voltage and/or current sensor;
determining, at the interrogator, a time at which the optical signal originated from the voltage and/or current sensor by deducting the time delay to from the time t at which the optical signal was received;;
calculating, at the interrogator, a phasor from the received optical signal; and
time-stamping the phasor with the time at which the optical signal originated from the voltage and/or current sensor.

The optical fibre may be comprised in a power cable. The method may comprise illuminating the optical fibre using a broadband light source.

Preferably, the voltage and/or current sensor comprises a fibre Bragg grating in contact with a piezoelectric element which expands and contracts responsive to a sensed voltage and/or current.

Preferably, calculating a phasor comprises determining the sensed voltage and/or current from the received optical signal. Preferably, the sensed voltage and/or current is determined from a spectral position of a peak reflection wavelength from the fibre Bragg grating. Preferably, changes in the sensed voltage and/or current are determined from changes in the peak reflection wavelength.

Preferably, the fibre Bragg grating of the voltage and/or current sensor (or each fibre Bragg grating of a plurality of voltage and/or current sensors) has a unique peak reflection wavelength. Accordingly, the or each fibre Bragg grating can be interrogated and uniquely identified using, for example, a wavelength division multiplexer. A time division multiplexer may be used if the or each fibre Bragg grating does not have a unique peak reflection wavelength.

Optionally, the time synchronisation signal comprises a pulse-per-second signal or a network time protocol signal. The time synchronisation signal may be derived from a GPS signal.

Preferably, the time delay may be determined by transmitting a signal to the voltage and/or current sensor, receiving the signal after it has been reflected at the voltage and/or current sensor, and determining a round trip time 2*tₛ* for the signal. Transmitting a signal may comprise introducing a perturbation to the amplitude of a light source illuminating the optical fibre. Receiving the signal may comprise detecting an effect of the perturbation on light reflected by the voltage and/or current sensor.

Preferably, receiving the signal may comprise separating a proportion of the light reflected by the voltage and/or current sensor using an optical coupler and detecting it with a photodetector.

Preferably, calculating the phasor from the received signal comprises calculating a vector comprising the magnitude and phase of the sensed voltage and/or current. Optionally, the phase of the sensed voltage and/or current is offset by the or a phase delay ϕ corresponding to the time delay *tₛ*.

Optionally, calculating the phasor comprises calculating a Fourier transform of a time series of the sensed voltage and/or current.

Preferably, the method comprises continually receiving signals from the voltage and/or current sensor, continually calculating phasors from the received signals, and continually time-stamping the phasors. Optionally, the method comprises periodically determining the time delay corresponding to the voltage and/or current sensor.

Preferably, the method comprises receiving a plurality of signals from a corresponding plurality of voltage and/or current sensors, calculating a corresponding plurality of phasors, and time-stamping each of the phasors. The method may comprise periodically determining a time delay corresponding to each of the plurality of voltage and/or current sensors. Each of the plurality of signals may comprise a wavelength unique to the corresponding voltage and/or current sensor.

Optionally, the method further comprises delivering a control signal (or one or more control signals) to a location (or one or more locations) along the/an optical fibre. The location (or locations) may be associated with a voltage and/or current sensor (or sensors) and may be co-located with the voltage and/or current sensor (or sensors). The control signal (or signals) may be delivered to the location responsive to analysis performed on the measured synchrophasor. Accordingly, the method may also comprise analysing the synchrophasor.

Preferably, the method comprises transmitting the one or more control signals along the optical fibre and receiving at least one control signal at a control module. The control signal may be transmitted at a different wavelength from the signal (or signals) received from the voltage and/or current sensor (or sensors).

Preferably, the method comprises delivering a plurality of control signals to a plurality of control modules along the optical fibre. The plurality of control signals may be transmitted at a corresponding plurality of wavelengths, each of which may be different from a wavelength (or wavelengths) of the signal (or signals) received from the voltage and/or current sensor (or sensors).

Preferably, delivering the control signal (or one of the plurality of control signals) to the control module (or one of the plurality of control signals) may comprise code-multiplexing and/or wavelength multiplexing.

Code-multiplexing may comprise transmitting a plurality of control signals at a single wavelength, receiving the plurality of control signals at the control module, and determining which of the plurality of control signals are intended for the control module.

Wavelength multiplexing may comprise transmitting a plurality of control signals at a plurality of wavelengths, receiving the plurality of control signals at the control module, and detecting one or more control signals transmitted at a wavelength unique to the control module.

According to a second aspect of the invention there is provided a monitoring system for making a time-synchronised phasor measurement comprising:
an interrogator in optical communication with one or more voltage and/or current sensors via an optical fibre, the interrogator configured to;
receive one or more optical signals from the one or more voltage and/or current sensors;
receive a time synchronisation signal;
determine a time t at which each optical signal was received, at the interrogator, from the respective voltage and/or current sensor;
determine a time delay *tₛ* corresponding to each voltage and/or current sensor;
determine a time at which the optical signal originated from each voltage and/or current sensor by deducting the respective time delay *tₛ* from each time t at which the optical signals were received;
calculate one or more phasors from the one or more received optical signals; and
time-stamp the one or more phasors with the times at which the optical signals originated from each voltage and/or current sensor.

Preferably, the interrogator comprises a broadband light source to illuminate the optical fibre. The optical fibre may be comprised in a power cable. Each of the optical signals may comprise a wavelength unique to the corresponding voltage and/or current sensor.

Preferably, each voltage and/or current sensor comprises a fibre Bragg grating in contact with a piezoelectric element which expands and contracts responsive to a sensed voltage and/or current.

Preferably, the interrogator is configured to determine each sensed voltage and/or current from the received optical signal. Preferably, each sensed voltage and/or current is determined from a spectral position of a peak reflection wavelength from the or each fibre Bragg grating. Preferably, changes in the sensed voltage and/or current are determined from changes in the peak reflection wavelength.

Preferably, the fibre Bragg grating of each voltage and/or current sensor has a unique peak reflection wavelength, and the interrogator may comprise a wavelength division multiplexer. Alternatively, the interrogator may comprise a time division multiplexer.

Preferably, the interrogator is configured to transmit a signal to each voltage and/or current sensor, receive the signal after it has been reflected at the or each voltage and/or current sensor, and determine a time delay corresponding to the or each voltage and/or current sensor. The interrogator may be configured to introduce a perturbation to the amplitude of a light source illuminating the optical fibre. The interrogator may be configured to detect an effect of the perturbation on light received and reflected by the or each voltage and/or current sensor. Preferably, the interrogator comprises an optical coupler and a photodetector configured to detect a proportion of the light reflected by the or each voltage and/or current sensor.

Preferably, the interrogator is configured to calculate a vector comprising the magnitude and phase of the or each sensed voltage and/or current. Optionally, the phase is offset by a phase delay ϕ corresponding to the sensed voltage and/or current. Optionally, the interrogator is configured to calculate a Fourier transform of a time series of the or each sensed voltage and/or current.

Preferably, the interrogator is configured to continually receive signals from each voltage and/or current sensor, continually calculate phasors from the received signals, and continually time-stamp the phasors. The interrogator may periodically determine the time delay t and optionally the phase delay ϕ corresponding to each voltage and/or current sensor to calibrate the monitoring system.

Optionally, the interrogator is configured to deliver a control signal to a control module via the optical fibre. The control module may be associated with a voltage and/or current sensor, and may be co-located with the voltage and/or current sensor, or it may be separate from the or each voltage and/or current sensor. The interrogator may be configured to deliver the control signal responsive to analysis of a corresponding synchrophasor.

Optionally, the interrogator is configured to transmit the control signal at a different wavelength from the signals received from the or each voltage and/or current sensor.

Preferably, the interrogator is configured to transmit a plurality of control signals to a plurality of control modules via the optical fibre. The plurality of control signals may be transmitted at a corresponding plurality of wavelengths, each of which may be different from the wavelength of the signals received from the or each voltage and/or current sensor. Alternatively, the plurality of control signals may be transmitted at a single wavelength. In either case, the or each control module is preferably configured to detect only the control signal which is intended for that control module.

Optionally, the control module comprises a photodetector, and a filter configured to separate the control signal from any other signals received by the control module via the optical fibre.

Optionally, the filter comprises an optical add/drop multiplexer. Optionally, the filter comprises a fibre Bragg grating and an optical circulator arranged to drop signals at a desired wavelength. Preferably the fibre Bragg grating is weakly reflecting at the desired wavelength.

Alternatively, the filter comprises a fibre coupler arranged to couple a portion of the control signal from the optical fibre to the photodetector via a narrowband filter.

Alternatively, the filter comprises a wavelength division multiplexer. Optionally, the filter further comprises a fibre coupler arranged to couple a portion of the control signal from the wavelength division multiplexer to the photodetector via a narrowband filter. Optionally, the control module further comprises a fibre coupler arranged to couple the remaining control signal from the wavelength division multiplexer to the optical fibre.

Alternatively, the filter comprises a fibre coupler and an optical add/drop multiplexer, the fibre coupler arranged to couple a portion of the control signal to the optical add/drop multiplexer, and the optical add/drop multiplexer configured to drop signals at a desired wavelength to the photodetector. Preferably the optical add/drop multiplexer comprises a fibre Bragg grating and an optical circulator, wherein the fibre Bragg grating is weakly reflecting at the desired wavelength. Optionally, the control module further comprises a fibre coupler arranged to couple the remaining control signal from the optical add/drop multiplexer to the optical fibre.

It is also envisaged that advantages of preferred or optional features of the foregoing aspects may be employed, independently of calculating or determining a phasor, to provide a means of time-stamping any signal or associated measurement.

Accordingly, a third aspect of the invention provides a method of time-stamping a signal from a voltage and/or current sensor comprising:
receiving, at an interrogator, an optical signal from the voltage and/or current sensor;
determining, at the interrogator, a time t at which the optical signal is received from the voltage and/or current sensor;
determining, at the interrogator, a time delay *tₛ* corresponding to the voltage and/or current sensor;
determining, at the interrogator, a time at which the optical signal originated from the voltage and/or current sensor by deducting the time delay *tₛ* from the time t at which the optical signal is received; and
time-stamping the optical signal, or a measurement derived from the optical signal, with the time at which the optical signal originated from the voltage and/or current sensor.

According to a fourth aspect of the invention there is provided a monitoring system comprising:
an interrogator in optical communication with one or more voltage and/or current sensors via an optical fibre, the interrogator configured to:
receive one or more optical signals from the one or more voltage and/or current sensors;
determine a time t at which each optical signal is received from the one or more voltage and/or current sensors;
determine a time delay *tₛ* corresponding to each voltage and/or current sensor;
determine a time at which each optical signal originated from the respective voltage and/or current sensor by deducting the respective time delay *tₛ* from the respective time t at which the signal is received; and
time-stamp the one or more optical signals, or measurements derived from the optical signals, with the times at which the optical signals originated from respective voltage and/or current sensors.

### Brief description of the drawings

There will now be described, by way of example only, various embodiments of aspects of the invention with reference to the drawings, of which:
Figure 1 illustrates a fibre Bragg grating based optical voltage sensor;
Figure 2 illustrates an optical fibre sensor monitoring system;
Figure 3 illustrates in schematic form a monitoring system according to an aspect of the invention;
Figure 4 is a simulation of the delay time from different sensor locations in a monitoring system such as that illustrated in Figure 3; and
Figure 5 is a schematic illustration of a number of different encoding and decoding approaches for sending and receiving control signals along an optical fibre.

### Detailed description of preferred embodiments

As discussed in the background to the invention above it is desirable to make multiple time-synchronised phasor ("synchrophasor") measurements at long distances and without the need for power supplies, reliance on GPS satellites or telecommunications networks. It is also desirable to communicate, and specifically to deliver control signals, to remote locations.

By utilising optical fibre, whether standalone or as incorporated in modern power cables or otherwise, the invention allows time-synchronised phasor measurements to be measured over very long distances (e.g. up to 100 km before signal boosting is required), without any requirement for power supplies, access to GPS satellites or indeed telecommunications equipment, at the measurement locations. The invention allows a high number of such measurement points to be placed at regular or strategic locations along a power cable without using more than a single fibre core (although multiple cores may be employed). Furthermore, control signals can be sent to one or more of several different locations over very long distances, again utilising optical fibre which may be standalone or as incorporated in modern power cables or otherwise.

### Fibre Bragg Grating Optical Fibre Sensor

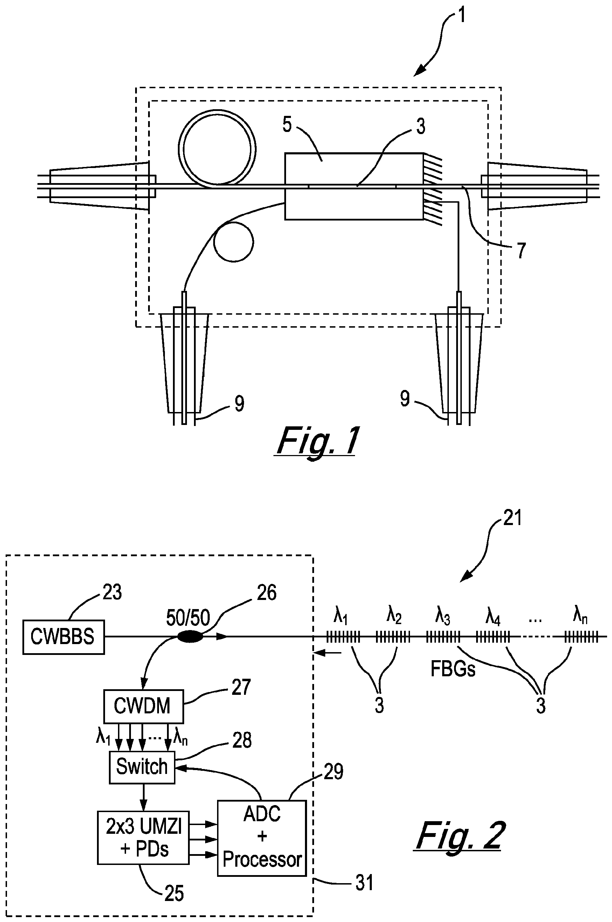

By way of introduction and to provide context for the description of preferred and alternative embodiments which follow, Figure 1 illustrates a sensor 1 which combines an optical strain sensor with a piezo-electric element to provide a mechanism for the measurement of voltage at a remote location. The optical strain sensor comprises a fibre Bragg grating (FBG) 3 which is written in the core of an optical fibre 7 using standard writing technologies (such as UV interference and masking). The FBG 3 will reflect at the Bragg wavelength, λ*_{B}*=2*nΛ*, where *n* is the effective core index of refraction and *Λ* the pitch of the grating. Accordingly, FBG 3 effectively acts as a wavelength-specific reflector; the peak reflection wavelength dependent on the periodicity of the variation in the refractive index in the fibre core (i.e. the pitch of the grating).

In this example a piezo-electric element 5 (which may be a piezo-electric stack) is in physical contact with (e.g. bonded to) the optical fibre in the region of the FBG 3. As the piezo-electric element 5 expands and contracts under an applied voltage (via terminals 9), the FBG 3 is also made to expand and contract thus altering the pitch of the grating and hence the Bragg wavelength. The instantaneous spectral position of the peak reflection wavelength of the FBG 3 is therefore indicative of the voltage applied to the piezo-electric element 5. Accordingly, a monitoring system (see below) can be configured to determine the voltage applied to the piezo-electric element 5 using the instantaneous spectral position of the peak reflection wavelength.

In an alternative example, the FBG may not be attached directly to the piezo-electric element, and instead 'strung' between end caps that are attached to the piezo-electric element. In such an arrangement, the strain may be equalised over the grating, the fibre may be pretensioned, and the mechanical strain transfer may be increased, resulting in improved performance compared to the direct attachment arrangement above.

Such a sensor may also be employed as a current sensor by connecting the piezoelectric element and bonded FBG in parallel with a current transformer (CT) and a burden resistor. Monitoring the secondary current of the CT, transformed into a voltage via the burden resistor, provides a measure of the primary current in a cable enclosed by the CT. A Rogowski coil, which has a dielectric core, may be used in place of the CT.

### Optical Fibre Sensor Monitoring System

Figure 2 illustrates in schematic form a monitoring system 21 suitable for monitoring a plurality (n) of FBGs 3 in an optical fibre 11. Each FBG 3 is sensitive to a different wavelength of light (λ₁, λ₂, λ₃, λ₄... λₙ) by appropriate selection of the periodicity of the variation in the refractive index of the fibre core (i.e. the pitch of the grating - see above).

The system comprises a broadband light source 23 for illuminating the optical fibre 11 with an interrogation signal which has a wavelength range covering the reflection wavelengths of all the FBGs 3 located along the optical fibre 11. Light passes along the fibre 11 and light reflected from each of the FBGs 3 is simultaneously and continuously fed into a wavelength division multiplexer 27 (via a coupler 26) which separates light received from the optical fibre 11 into a plurality of wavelengths (and associated fibres) each corresponding with one of the FBGs 3. A fast optical path switch 28, driven by ADC/Processor unit 29, guides the reflected signal from each FBG 3 in turn to an interferometer and demodulation platform 25.

The ADC/Processor unit 29 then processes the output from the interferometer and demodulation platform 25 to determine the wavelength of the reflected light in each channel and thereby determine the instantaneous voltage being applied to the piezo-electric element associated with the respective FBG 3. This can be done, for example, by comparing the instantaneous spectral position of the reflection peak with calibration data or a look-up table.

Alternatively, a time division multiplexer (not shown) can be used to separate light received from the optical fibre 11 into a time-separated series. In such an arrangement, the FBGs 3 are not required to exhibit unique peak reflection wavelengths. A combination of time division and wavelength division multiplexing techniques may be used to interrogate very large arrays of FBGs.

Reference numeral 31 generally indicates an interrogator which comprises the broadband light source 23, wavelength division multiplexer 27 and fast optical path switch 28 driven by ADC/Processor unit 29 (which could be replaced with or supplemented by a time division multiplexer), and interferometer and demodulation platform 25.

### Time-Synchronised Phasor Measurements

As discussed in the background to the invention above, a phasor is a vector quantity comprising the amplitude and phase of an AC electrical signal - typically voltage or current - and a synchrophasor is a phasor with the addition of a time-stamp which represents the precise time at which the measurement was made.

As also discussed in the background to the invention above, synchrophasors are typically calculated at or near the measurement location by a PMU which requires a power supply, access to the GPS network for an absolute time reference, and a traditional telecommunications network to transmit the calculated phasors from the measurement location.

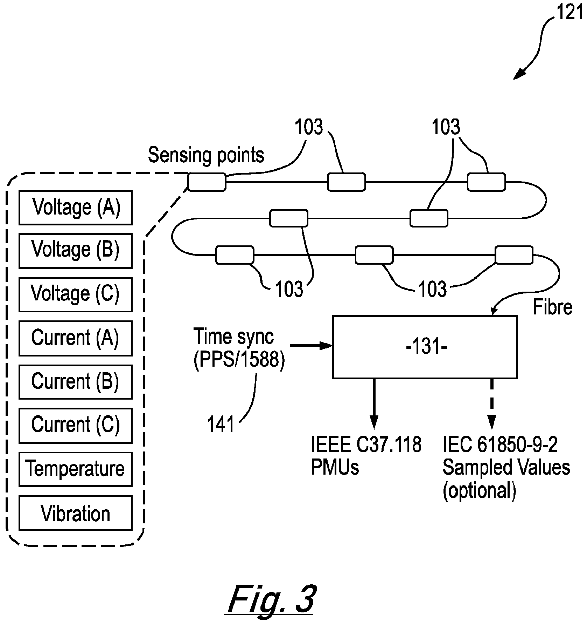

In contrast, monitoring system 121 according to an embodiment of the present invention (see Figure 3) employs an array of the above-described fibre bragg grating optical fibre sensors 103, each of which allow remote, passive measurement of voltage and/or current over long distances. Such sensors 103 may be primary-connected, secondary-connected (e.g. retrofitted to capture data from existing analogue electrical sensors), or integrated into equipment, according to the particular requirements of each measurement location. As with monitoring system 21 described above these are connected to the interrogator 131 by optical fibre line 101.

As in the monitoring system 21 described with reference to Figure 2, the interrogator 131 measures and tracks each peak reflected wavelength from sensors 103 and by analysing changes in the peak reflected wavelength determines a change in voltage and/or current associated with each sensor 103. However, the interrogator 131 will also calculate and time-stamp phasors continually for each sensor 103 and (optionally or alternatively) deliver control signals to remote locations. To achieve this, the interrogator 131 comprises the basic measurement platform required to determine a voltage and/or current measurement associated with each sensor 103, and is further adapted, configured or arranged to implement a time-stamp calibration process, further adapted, configured or arranged to implement a phasor calculation and network streaming process, and/or a method for passive control of remote devices, as will be described in the following sections.

Note it is envisaged that other sensors and sensing arrangements may benefit from the technical contribution made by the invention in its many and varied embodiments; as such it will be understood that the invention is not limited to use with sensors of the type described with reference to Figure 1 or the specific interrogation arrangement or monitoring system described with reference to Figure 2, which are primarily used for the purposes of describing working embodiments of the invention.

### Time Stamp Calibration

The interrogator 131 takes as an input a time synchronisation signal 141 (for example a Pulse-Per-Second (PPS) signal or a Precision Time Protocol (PTP) signal) which allows the time at which each optical signal is received from each respective sensor 103 to be known with an accuracy of, typically, at least one microsecond.

For sensors 103 close to the interrogator 131, this time stamp could be used without modification to time-stamp the phasor calculation of respective sensor signals. However, it is a stated aim of the present invention to make such measurements at long distances since the Applicant's proprietary sensors can be installed significant distances from the interrogator (as noted above, up to 100 km before signal boosting is required), in which case it is necessary to adjust or compensate for the finite "time of flight" of the light travelling from a particular sensor 103 to a corresponding detector in the interrogator 131.

The time delay *tₛ* associated with the optical signal travelling from a remote sensor location to the interrogator 131 can be determined from the speed of light in the fibre between the sensor and the interrogator, which is simply c/n where c is the speed of light in a vacuum and *n* is the average refractive index of the fibre core over this path. Generally, the value of *n* in standard single-mode telecommunications fibre will be approximately 1.4682, corresponding to a speed of light in fibre of around 204.19 metres per microsecond. This corresponds to a time delay (as a function of distance) *tₛ* of around 4.9 µs/km.

Taking (for example) a desired time accuracy of at least one microsecond, compensation will be required at least for those sensors that are located more than around 200 metres from the interrogator. Of course, it may be desirable to increase this accuracy, or lower accuracy may be tolerable, but for the purposes of explaining the principles of the invention this embodiment assumes it is desirable to obtain an accuracy of at least one microsecond regardless of the distance from or proximity to the interrogator 131 of respective sensors 103.

The speed of light in fibre, and therefore *tₛ*, will also vary with the average temperature along the path of the light. The Applicant has performed modelling of the effect of expected UK and global outdoor temperature swings on the time stamp calibration process described herein and has determined that one calibration of *tₛ* per month may be sufficient to keep any error well below the above requirements for time-stamp accuracy. It is possible that a twice-yearly calibration may be sufficient but, as will be clear from the following discussion, the preferred calibration process is not disruptive and so may be performed regularly to ensure high temporal accuracy of measurements.

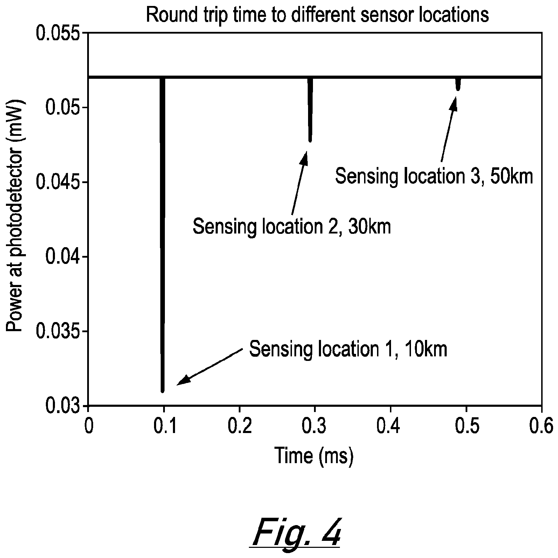

The preferred method for calibration of *tₛ* of each sensor 103 in an array is based upon measurement of the time taken for light to complete simultaneous round trips from the interrogator 131 to each sensor 103 and back. In normal operation of the invention (in its preferred embodiment at least), the light source (not shown) operates in a 'continuous wave' mode. By introducing a perturbation (such as a step change or modulation) to the amplitude of the light source at a known point in time, the effect of this perturbation on the reflected signals from each of the sensors 103 may be detected. The round-trip time for a particular sensor 103, which is the time between introducing the perturbation and detecting its effect on the reflected signal from that sensor 103, is 2**tₛ* (since it comprises both outbound and return trips) and therefore *tₛ* can be easily determined with minimal disruption to the monitoring system 121. Figure 4 illustrates the round-trip time corresponding to three different sensor locations along optical fibre line 101; location 1 at 10 km; location 2 at 30 km; and location 3 at 50 km, as well as an indication of the respective signal strengths which show that even at distances of 50 km these signals can be detected. By way of explanation, Figure 4 represents the source power being very briefly switched off, which creates a 'blip' of low power, and the detection of that blip in power in the reflections received from each sensor in turn.

In order to measure *tₛ*, the interrogator is configured to (a) modulate or otherwise introduce a perturbation into the light source output used to illuminate the optical fibre line 101 at a specific point in time, and (b) measure the time of return of this feature (its effect on the signal) after reflection from each sensor and discriminate between the arrival of each sensor's reflected feature.

Modulation of the light source can be achieved in a variety of ways, including: by direct voltage control of certain sources; by control of optical attenuators placed at the source output; by control of an optical switch placed at the source output. This is not an exhaustive list and there are many more ways to introduce some form of variation of amplitude into a light source which the skilled person will readily be able to implement.

Measuring the time of arrival of the amplitude change upon return from each sensor may also be achieved in a variety of ways. As described above in relation to the optical fibre sensor monitoring system 21 illustrated in and described with reference to Figure 2, signals from individual sensors can be discriminated using WDM or TDM in the same way that voltage and/or current measurement signals can be discriminated.

However, a simple approach is to use an optical splitter or coupler to separate off a proportion of the reflected light (e.g. 5% of the amplitude) returning along the optical fibre. The remaining (e.g. 95%) received optical power is detected and processed as usual, while the 5% is directed to a simple high-speed photodetector (e.g. photodiode and transimpedance amplifier). Following the perturbation of the light source output, the output of the photodetector will comprise a time series of features representing the arrival of the reflected perturbation from each sensor in turn, starting with the physically closest sensor and ending with the more distant sensor (distance as measured along the optical fibre and not necessarily "as the crow flies" from the interrogator). The output of the photodetector can be analysed, for example using an analogue electronic circuit, to detect the occurrence of the features in the reflected light. This can be achieved by thresholding to produce a digital indicator signal. The time difference between the gating of the feature in the source to the detection of this digital indicator then represents 2**tₛ* as discussed above.

Note that although the above described arrangement and process eliminates dependence on GPS for time-stamping, which is desirable for many reasons, it is conceivable that the time synchronisation signal input to the interrogator could be derived from a GPS signal. Significant advantages would still be realised in this case; for example, the individual sensors would still not depend upon GPS for the time stamp calibration to function, as the time-stamping is carried out by the interrogator 131. In any case, even in the event of GPS failure there would still be a relative time delay calibration between sensor signals.

Although in the present application the invention (in its various aspects) is primarily described in the context of making time synchronised phasor measurements, it will be understood that the foregoing time stamp calibration process can, alternatively or in addition to time-stamping phasors, be used to time stamp any received signals and/or measurements derived from those signals (for example voltage, current, or both).

Accordingly, following the teachings of the present application not only provides a means to make time synchronised phasor measurements, but also time synchronised measurements of voltage and/or current, or indeed any other measurement.

In an illustrative example, a signal is received from a sensor, for example a voltage and/or current sensor. A time t at which the signal is received is determined, for example by utilising a time synchronisation signal. A time delay *tₛ* corresponding to the sensor is determined, for example by modulation of a light source and detecting the effect of the modulation in the manner described above. The time at which the signal originated from the sensor can be determined by deducting the time delay *tₛ* from time t, and thereafter the received signal can be time stamped (with the time at which the signal originated from the sensor). If the signal is processed to determine a measurement, such as a voltage and/or current measurement, that measurement may also (or instead) be time-stamped with the time at which the signal originated from the sensor.

### Production of Synchrophasors

As described above, synchrophasors are time-stamped phasor measurements of electrical quantities; typically, voltage and/or current. There are therefore two determinations in the production of a synchrophasor: (a) establishing the absolute time at which the sample was taken; and (b) calculating a vector comprising the magnitude and phase of the measured electrical signal at the time the sample was taken. However, as will be described below, rather than establishing the absolute time at which the sample was taken, a synchrophasor can alternatively be produced by (a) establishing the absolute time at which the sample was received; and (b) calculating a vector comprising the magnitude and phase of the measured electrical signal at the time the sample was received.

The former approach provides a synchrophasor at the time the sample was taken, and the latter approach provides a synchrophasor at the time the sample was received (effectively providing a real time measurement of the synchrophasor).

There is described above a preferred approach for establishing the time of flight *tₛ* between the location of a sensor 103 and the interrogator 131. Given this value, the absolute time at which the measurement was taken (as relevant to the former approach) is simply the absolute current time t, derived from the time synchronisation input, minus *tₛ*. Thus, the time-stamp is simply *t - tₛ.*

In the latter approach, rather than determining the absolute time at which the measurement was taken, the time stamp can simply be t (the time at which the sample was received) and the time of flight *tₛ* instead used to determine the phase of the measured electrical signal at the time the sample was received. This can be achieved by converting the time *tₛ* into a corresponding phase delay ϕ based upon the frequency *f* of the monitored system - usually 50/60Hz - and by expressing *tₛ* as a fraction of the total wave period 1/f. For example, if the period was 20 ms (50 Hz system) and the delay was 10 ms then the phase delay ϕ would be 180°. The phasor would then be calculated taking the phase delay ϕ into account and time stamped with t to provide a synchrophasor at the time the sample was received.

Calculation of a phasor from time series data can be performed in a variety of ways, as is/are known to the person skilled in the art, the most common being the calculation of the Fourier transform of the time series data. Popular and practical implementations on digital systems are well-known, such as the Discrete Fourier Transform (DFT) and the Fast Fourier Transform (FFT) which produce the frequency domain decomposition of the time series data, from which the magnitude and phase of the fundamental (generally 50 or 60 Hz for ac power systems) may be extracted. The frequency of the fundamental can also be extracted at this point by straightforward analysis.

Having established the absolute time at which the sample was taken, or the absolute time at which the sample was received, and having calculated a vector comprising the magnitude and phase of the measured electrical signal, a synchrophasor is determined therefrom. As described above, this is achieved without power supplies at any measurement location, without GPS equipment at any measurement location (or indeed anywhere), and without telecommunication equipment at or associated with any measurement location.

There will now be described a further optional feature of the interrogator and/or monitoring system which enhances the functionality of the interrogator, monitoring system and/or power network in which it is implemented. It should be noted that the passive control signal delivery approach which follows may be implemented without the interrogator, although for the purposes of illustrating a working example it is described in this context.

### Passive Control Signal Delivery

As intimated above, a further optional feature of the above-described monitoring system provides a means for passively delivering analogue or digital control signals to a remote location. This location may be but is not necessarily associated with a sensor module connected to the interrogator, and for clarity even if associated with one it is not required that a sensor module is co-located. The control module described here is a passive, stand-alone module, which is connected to the fibre in the same way as the fibre Bragg grating optical sensor described above (although it is envisaged that such a sensor, or at least a monitoring system comprising such a sensor, could be modified to receive control signals). Control signals may be sent responsive to the results of analysis performed on the synchrophasors determined as above, for example to vary generation or load in response to system stability analysis based on the phasor measurement data, or to communicate a command signal to a switch or relay.

Whereas the electrical terminals of the fibre brag grating optical sensors described above serve as voltage inputs on which a measurement is performed, the control module's electrical terminals will serve as outputs which can be connected to a nearby electrical or electronic module to deliver control signals. Such a control module may take (at least) one of a number of forms and operate in (at least) one of two ways as explained below.

In a preferred embodiment, a control signal wavelength, λ_{c}, may be located at the edge of the telecommunication band. In this way, the possibility of cross talk between control signals and sensor signals is made negligible. Alternatively, sensor bandwidth requirement may dictate that λ_{c} lies outside the broadband source bandwidth utilised by the sensor FBGs. For instance, if the design wavelengths of the FBGs in the optical sensors are restricted to the telecommunications band of approximately 1530 nm to 1590 nm, then the design wavelengths of the FBGs in the control modules may be restricted to other low loss regions (e.g. around 1310 nm). Sensing and control wavelengths can be combined using a dual-window fibre coupler for example.

To send control signals from the interrogator 131 to a control module disposed at some location along the optical fibre 100, the control modules may be configured to receive optically-encoded control signals. This can be achieved by modulating the amplitude of the optical signal at λ_{c} as with conventional optical digital telecommunication systems. In this manner, any variation in the amplitude of light at λ_{c} will give rise to a corresponding variation in the electrical voltage at the output of a photodetector associated with the respective FBG. Using this relationship between optical amplitude modulation at λ_{c} and electrical modulation at the control module (which may be located a substantial distance from the interrogator), remote delivery of analogue or digital voltage signals for control purposes may be achieved.

Where multiple control modules are disposed along one fibre line, it is preferred to be able to discriminate between control signals such that only the desired control module (or modules as the case may be) will or is able to receive the control signal intended for it (them). Two preferred ways to achieve this are by code-multiplexing and/or by wavelength-multiplexing.

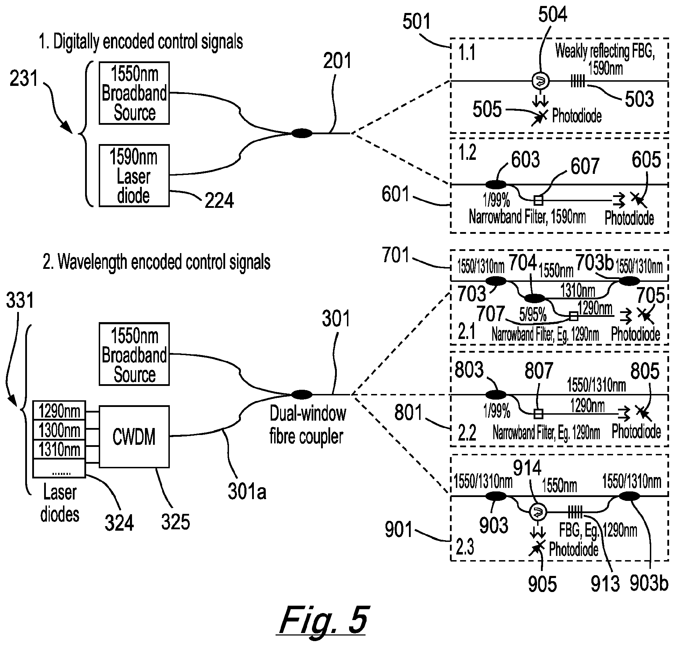

All control modules could operate at an identical wavelength and a control signal may be delivered to the required control module by virtue of a unique digital code which is interpretable only by the control module intended to receive it. Alternatively (or additionally), control signals can be wavelength-encoded, whereby each control module is assigned a unique wavelength (in the same way that individual sensor modules can be assigned a unique wavelength - defined by an FBG). These two approaches require different components at both the transmitting and receiving end, as illustrated in Figure 5. In the embodiments described herein the control signal, λ_{c}, is separated from the sensing signals at the receiver one way or another. In each case, the arrangement of features which separate the control signal from any other signals received by the control module is effectively, and can therefore be thought of collectively as, a filter.

### 1. Digitally-encoded control signals

In this approach the same wavelength is used for all control modules, thereby requiring only one narrowband transmitter/transceiver in the interrogator 231. The following description assumes the λ_{c} is located inside the sensing bandwidth. However, as noted above it may be necessary or otherwise desirable to locate λ_{c} outside the sensing bandwidth; in this case, standard telecommunication dual-wavelength components can be used.

At the interrogator 231, a single narrow-linewidth laser diode 224 is used to send one signal to all control modules (e.g. 501 or 601) along optical fibre line 201. The high power spectral density of a laser diode permits signals to be detected by an optical detector (e.g. 505 or 605), when the control wavelength, λ_{c} is placed inside the bandwidth of the broadband sensor source. Signals intended for a specific control module can be encoded in such a way that each receiver can extract its intended message. At each control module, receiver electronics would process the signal only if a signal is sent with a code sequence corresponding to that particular control module. There are several options to couple the required control signal from the sensing fibre into a receiver within the control module, two of which are described below.

In a first embodiment, the control signal is dropped by control module 501 using a modified version of an optical add/drop multiplexer (OADM) connected directly to the sensing fibre line 201. The OADM uses a fibre Bragg grating (FBG) 503 and a passive optical circulator 504. In this context, the wavelength-selective reflection that is characteristic of the FBG 503 is used as a wavelength filter. In the control module 501, the FBG/circulator arrangement 503,504 can be used to 'drop' signals at a particular wavelength out of the fibre path at a particular location, without this operation having any effect on the other FBG wavelengths as used for sensing. This is also advantageous if, for example (and as mentioned below), a combination of digital encoding and wavelength encoding is employed.

In any case, it is preferable to employ a weakly reflecting FBG, so that the control signal can reach all control modules on the fibre line. Only a small percentage (e.g. 1-5%) of the control signal may be coupled to the photodiode 505 of the control module; the majority of the control signal continuing along the optical fibre line 201.

Alternatively, as shown in control module 601, a passive fibre coupler (FC) 603 can be used to couple a small proportion (e.g. 1-5%) of both sensing and control signals to a photodiode 605 via a narrowband filter 607, such as a Fabry Perot (FP) or thin-film filter, to prevent the sensing signal from reaching the photodiode 605.

### 2. Wavelength-encoded control signals

In this approach unique control signal wavelengths are employed, typically one per control module.

Preferably a unique wavelength, for example in the range 1310 nm - 1350 nm, is assigned to each control module. Various techniques can be used to vary the amplitude of the optical signal at λ_{c} only. For example, light from a broadband source covering for instance the 1310 nm - 1350 nm range could be incident upon a filter or series of filters and mechanical or electronic gates or switches which are able to discretely modulate the power levels at wavelengths corresponding to the control modules (e.g. 701,801,901). Dedicated low-cost light sources such as light-emitting diodes (LEDs) could be used, one (or more) per control wavelength, which can be switched on and off or varied in power level. Alternatively, one or more standard telecommunication laser diode transmitters or transceivers 324 could be used in combination with a coarse wavelength division multiplexer (CWDM) 325 which combines all outputs into a single fibre 301a for coupling into the sensing fibre 301, as in interrogator 331.

In a first embodiment, control module 701 separates the sensing and control wavelengths using a broadband WDM 703. A proportion of the control band may then be coupled off (e.g. using a 5/95% coupler 704) and a narrowband filter 707 selects the control module specific wavelength and prevents other control wavelengths from reaching the photodiode 705. A second WDM 703b may be used to recouple the sensing and control wavelengths for onward transmission along the fibre line 301.

In a second embodiment, control module 801 couples off a small proportion of both sensing and control bands using a dual-wavelength fibre coupler (FC) 803. Like filter 707 in control module 701 above, narrowband filter 807 is used to ensure only the chosen control wavelength is received by the photodiode 805.

In a third embodiment, control module 901 couples off specific control wavelengths using a dual-wavelength-FC 903 and the 'drop' function of an OADM (comprising FBG 913 and circulator 914 - similar to control module 501 described above). In this way the control wavelength required by the control module is dropped and received by the photodiode 905. If, as in control module 501, a weakly reflecting FBG is employed, the remaining light at the control wavelength can be recoupled by a second dual-wavelength-FC 903b to the optical fibre line 301.

Although it is preferable that a unique wavelength is assigned to each control module, it is foreseen that several control modules arranged along the optical fibre may be configured to receive signals at the same wavelength. It may then be possible for an individual control module to detect a signal designated for that particular module by digitally encoding it as described in the previous section.

It should also be borne in mind that in the embodiments described above the optical fibre line 201,301 also carries light to and from an array of fibre Bragg grating based optical sensors, although it is envisaged that the above-described approach can be used to deliver control signals independently of any monitoring system, in which case there is no need to carry both sensing signals and control signals, and consequently no need to separate the control wavelengths from sensing wavelengths.

In summary, the key contributions made by the above-described features, embodiments and aspects of the invention lie in eliminating the requirement for power supplies, GPS equipment, and telecommunication equipment at each measurement and/or control location, as a result of which the complexity and cost of implementing a PMU network and/or a control system can be substantially reduced. In the case of implementing a PMU network, creation of synchrophasors is achieved by centralising the determining of phasors and corresponding time-stamps at a location away from the actual measurement locations. Alternatively, or in addition to time-stamping phasors, the invention enables the time-stamping of any received signals and/or measurements derived from those signals. These signals are received from appropriate sensors distributed along optical fibres such as may be incorporated in modern power cables. Likewise, control signals can be communicated along optical fibres such as may be incorporated in modern power cables, and a number of approaches to ensuring control signals are received by the intended control modules are provided. It is envisaged that either or both the PMU network and control system can be implemented in a power network by exploiting existing optical fibre infrastructure in this way. It is also envisaged that control signals can be transmitted dependent on analysis performed on synchrophasors.

Throughout the specification, unless the context demands otherwise, the terms "comprise" or "include", or variations such as "comprises" or "comprising", "includes" or "including" will be understood to imply the inclusion of a stated integer or group of integers, but not the exclusion of any other integer or group of integers.

## Claims

1. A method of making a time-synchronised phasor measurement comprising:
receiving, at an interrogator (131), an optical signal from a voltage and/or current sensor (103) via an optical fibre (101);
**characterised in that** the method further comprises:
receiving, at the interrogator (131), a time synchronisation signal (141);
determining, at the interrogator (131), a time t at which the optical signal was received from the voltage and/or current sensor (103);
determining, at the interrogator (131), a time delay to corresponding to the voltage and/or current sensor (103);
determining, at the interrogator (131), a time at which the optical signal originated from the voltage and/or current sensor (103) by deducting the time delay to from the time t at which the optical signal was received;
calculating, at the interrogator (131), a phasor from the received optical signal and
time-stamping the phasor with the time at which the optical signal originated from the voltage and/or current sensor (103).

2. The method of claim 1, wherein the time delay is determined by transmitting a signal to the voltage and/or current sensor (103), receiving the signal after it has been reflected at the voltage and/or current sensor (103), and determining a round trip time *2tₛ* for the signal.

3. The method of claim 2, comprising introducing a perturbation to the amplitude of a light source illuminating the optical fibre (101), and detecting an effect of the perturbation on light reflected by the voltage and/or current sensor (103).

4. The method of any preceding claim, wherein the optical fibre (101) is comprised in a power cable.

5. The method of any preceding claim, wherein calculating a phasor comprises determining the sensed voltage and/or current from the received optical signal.

6. The method of any preceding claim, wherein the voltage and/or current sensor (103) comprises a fibre Bragg grating (3) in contact with a piezoelectric element (5) which expands and contracts responsive to a sensed voltage and/or current, and wherein the sensed voltage and/or current is determined from a spectral position of a peak reflection wavelength from the fibre Bragg grating (3).

7. The method of any preceding claim, comprising determining a phase delay ϕ corresponding to the time delay *tₛ*, and wherein calculating the phasor from the received optical signal comprises calculating a vector comprising the magnitude and phase of the sensed voltage and/or current, wherein the phase of the sensed voltage and/or current is offset by the phase delay ϕ.

8. The method of any preceding claim, comprising receiving a plurality of optical signals from a corresponding plurality of voltage and/or current sensors (103), calculating a corresponding plurality of phasors, and time-stamping each of the phasors.

9. The method of claim 8, comprising continually receiving optical signals from each voltage and/or current sensor (103), continually calculating phasors from each received optical signal, and continually time-stamping each phasor.

10. The method of claim 8 or claim 9, comprising periodically determining a time delay and/or a phase delay corresponding to each voltage and/or current sensor (103).

11. The method of any preceding claim, further comprising delivering one or more control signals to one or more locations along the optical fibre and receiving at least one control signal at a control module (501,601, 701, 801, 901).

12. The method of claim 11, wherein the control signal is delivered to the one or more locations responsive to analysis performed on one or more measured synchrophasors.

13. The method of claim 11 or claim 12, wherein the one or more control signals are transmitted at a different wavelength or different wavelengths from the optical signal received from the voltage and/or current sensor (103).

14. The method of any of claims 11 to 13, comprising transmitting a plurality of control signals at a single wavelength, receiving the plurality of control signals at the control module (501,601), and determining which of the plurality of control signals are intended for the control module (501,601), and/or transmitting a plurality of control signals at a plurality of wavelengths, receiving the plurality of control signals at the control module (701,801,901), and detecting one or more control signals transmitted at a wavelength unique to the control module (701,801,901).

15. A monitoring system (121) for making a time-synchronised phasor measurement comprising:
an interrogator (131) in optical communication with one or more voltage and/or current sensors (103) via an optical fibre (101), **characterised in that** the interrogator is configured to perform the method of any preceding claim.

16. A method of time-stamping a signal from a voltage and/or current sensor (103) comprising:
receiving, at an interrogator (131), an optical signal from the voltage and/or current sensor (103);
**characterised in that** the method further comprises:
determining, at the interrogator (131), a time t at which the optical signal is received from the voltage and/or current sensor (103);
determining, at the interrogator (131), a time delay *tₛ* corresponding to the voltage and/or current sensor (103);
determining, at the interrogator (131), a time at which the optical signal originated from the voltage and/or current sensor (103) by deducting the time delay *tₛ* from the time t at which the optical signal is received; and
time-stamping the optical signal, or a measurement derived from the optical signal, with the time at which the optical signal originated from the voltage and/or current sensor (103).

17. A monitoring system (121) comprising:
an interrogator (131) in optical communication with one or more voltage and/or current sensors (103) via an optical fibre (101), wherein the interrogator is configured to;
receive one or more optical signals from the one or more voltage and/or current sensors (103);
**characterised in that** the interrogator is further configured to:
determine a time t at which each optical signal is received from the one or more voltage and/or current sensors (103);
determine a time delay *tₛ* corresponding to each voltage and/or current sensor (103);
determine a time at which each optical signal originated from the respective voltage and/or current sensor (103) by deducting the respective time delay *tₛ* from the respective time t at which the signal is received; and
time-stamp the one or more optical signals, or measurements derived from the optical signals, with the times at which the optical signals originated from respective voltage and/or current sensors (103).

## Patentansprüche

1. Ein Verfahren zur Durchführung einer zeitsynchronisierten Zeigermessung, das Folgendes umfasst:
Empfangen eines optischen Signals von einem Spannungs- und/oder Stromsensor (103) über eine optische Faser (101) an einem Abfragegerät (131);
**dadurch gekennzeichnet, dass** das Verfahren zudem Folgendes umfasst:
Empfangen eines Zeitsynchronisationssignals (141) am Abfragegerät (131);
Bestimmen eines Zeitpunkts t, zu dem das optische Signal vom Spannungs- und/oder Stromsensor (103) empfangen wurde, am Abfragegerät (131);
Bestimmen einer Zeitverzögerung *tₛ*, die dem Spannungs- und/oder Stromsensor (103) entspricht, am Abfragegerät (131);
Bestimmen eines Zeitpunkts, zu dem das optische Signal vom Spannungs- und/oder Stromsensor (103) ausgegangen ist, durch Abziehen der Zeitverzögerung *tₛ* von dem Zeitpunkt t, zu dem das optische Signal empfangen wurde, am Abfragegerät (131);
Berechnen eines Zeigers aus dem empfangenen optischen Signal am Abfragegerät (131) und
Zeitstempeln des Zeigers mit dem Zeitpunkt, zu dem das optische Signal vom Spannungs- und/oder Stromsensor (103) ausgegangen ist.

2. Das Verfahren nach Anspruch 1, wobei die Zeitverzögerung durch Senden eines Signals an den Spannungs- und/oder Stromsensor (103), das Empfangen des Signals, nachdem es am Spannungs- und/oder Stromsensor (103) reflektiert wurde, und das Bestimmen einer Umlaufzeit von *2tₛ* für das Signal bestimmt wird.

3. Das Verfahren nach Anspruch 2, das das Einführen einer Störung in die Amplitude einer Lichtquelle, die die optische Faser (101) beleuchtet, und das Erfassen einer Auswirkung der Störung auf das vom Spannungs- und/oder Stromsensor (103) reflektierte Licht umfasst.

4. Das Verfahren nach einem der vorhergehenden Ansprüche, wobei die optische Faser (101) in einem Stromkabel enthalten ist.

5. Das Verfahren nach einem der vorhergehenden Ansprüche, wobei das Berechnen eines Zeigers das Bestimmen der erfassten Spannung und/oder des erfassten Stroms aus dem empfangenen optischen Signal umfasst.

6. Das Verfahren nach einem der vorhergehenden Ansprüche, wobei der Spannungs- und/oder Stromsensor (103) ein Faser-Bragg-Gitter (3) in Kontakt mit einem piezoelektrischen Element (5) umfasst, das sich als Reaktion auf eine erfasste Spannung und/oder einen erfassten Strom ausdehnt und zusammenzieht, wobei die erfasste Spannung und/oder der erfasste Strom aus einer spektralen Position einer Spitzenreflexionswellenlänge vom Faser-Bragg-Gitter (3) bestimmt wird.

7. Das Verfahren nach einem der vorhergehenden Ansprüche, das das Bestimmen einer Phasenverzögerung ϕ umfasst, die der Zeitverzögerung *tₛ* entspricht, und wobei das Berechnen des Zeigers aus dem empfangenen optischen Signal das Berechnen eines Vektors umfasst, der die Größe und Phase der erfassten Spannung und/oder des erfassten Stroms umfasst, wobei die die Phase der erfassten Spannung und/oder des erfassten Stroms um die Phasenverzögerung ϕ verschoben ist.

8. Das Verfahren nach einem der vorhergehenden Ansprüche, das den Empfang einer Vielzahl optischer Signale von einer entsprechenden Vielzahl von Spannungs- und/oder Stromsensoren (103), das Berechnen einer entsprechenden Vielzahl von Zeigern und das Versehen jedes Zeigers mit einem Zeitstempel umfasst.

9. Das Verfahren nach Anspruch 8, das das kontinuierliche Empfangen optischer Signale von jedem Spannungs- und/oder Stromsensor (103), das kontinuierliche Berechnen von Zeigern aus jedem empfangenen optischen Signal und das kontinuierliche Zeitstempeln jedes Zeigers umfasst.

10. Das Verfahren nach Anspruch 8 oder Anspruch 9, das das periodische Bestimmen einer Zeitverzögerung und/oder einer Phasenverzögerung, die jedem Spannungs- und/oder Stromsensor (103) entspricht, umfasst.

11. Das Verfahren nach einem der vorhergehenden Ansprüche, das außerdem das Liefern eines oder mehrerer Steuersignale an eine oder mehrere Stellen entlang der optischen Faser und das Empfangen mindestens eines Steuersignals an einem Steuermodul (501, 601, 701, 801, 901) umfasst.

12. Das Verfahren nach Anspruch 11, wobei das Steuersignal als Reaktion auf eine an einem oder mehreren gemessenen Synchrophasoren durchgeführte Analyse an den einen oder die mehreren Orte geliefert wird.

13. Das Verfahren nach Anspruch 11 oder Anspruch 12, wobei das eine oder die mehreren Steuersignale bei einer oder mehreren anderen Wellenlängen als das vom Spannungs- und/oder Stromsensor (103) empfangene optische Signal übertragen werden.

14. Das Verfahren nach einem der Ansprüche 11 bis 13, das das Senden mehrerer Steuersignale bei einer einzigen Wellenlänge, den Empfang der mehreren Steuersignale am Steuermodul (501, 601) und das Bestimmen, welche der mehreren Steuersignale für das Steuermodul (501, 601) bestimmt sind, und/oder das Senden mehrerer Steuersignale bei mehreren Wellenlängen, das Empfangen der mehreren Steuersignale am Steuermodul (701, 801, 901) und Erkennen eines oder mehrerer Steuersignale, die bei einer für das Steuermodul eindeutigen Wellenlänge gesendet werden (701, 801, 901), umfasst.

15. Ein Überwachungssystem (121) zur Durchführung einer zeitsynchronisierten Zeigermessung, das Folgendes umfasst:
ein Abfragegerät (131), das über eine optische Faser (101) in optischer Kommunikation mit einem oder mehreren Spannungs- und/oder Stromsensoren (103) steht, **dadurch gekennzeichnet, dass** das Abfragegerät zur Durchführung des Verfahrens nach einem der vorhergehenden Ansprüche konfiguriert ist.

16. Ein Verfahren zum Zeitstempeln eines Signals von einem Spannungs- und/oder Stromsensor (103), das Folgendes umfasst:
Empfangen eines optischen Signals vom Spannungs- und/oder Stromsensor (103) an einem Abfragegerät (131);
**dadurch gekennzeichnet, dass** das Verfahren zudem Folgendes umfasst:
Bestimmen eines Zeitpunkts t, zu dem das optische Signal vom Spannungs- und/oder Stromsensor (103) empfangen wird, am Abfragegerät (131);
Bestimmen einer Zeitverzögerung *tₛ*, die dem Spannungs- und/oder Stromsensor (103) entspricht, am Abfragegerät (131);
Bestimmen eines Zeitpunkts, zu dem das optische Signal vom Spannungs- und/oder Stromsensor (103) ausgegangen ist, durch Abziehen der Zeitverzögerung *tₛ* von dem Zeitpunkt t, zu dem das optische Signal empfangen wird, am Abfragegerät (131);
Zeitstempeln des optischen Signals oder einer aus dem optischen Signal abgeleiteten Messung mit dem Zeitpunkt, zu dem das optische Signal vom Spannungs- und/oder Stromsensor (103) ausgegangen ist.

17. Ein Überwachungssystem (121), das Folgendes umfasst:
ein Abfragegerät (131), das über eine optische Faser (101) in optischer Kommunikation mit einem oder mehreren Spannungs- und/oder Stromsensoren (103) steht, wobei das Abfragegerät dazu konfiguriert ist,
ein oder mehrere optische Signale von dem einen oder den mehreren Spannungs- und/oder Stromsensoren (103) zu empfangen;
**dadurch gekennzeichnet, dass** das Abfragegerät weiterhin zu Folgendem konfiguriert ist:
Bestimmen eines Zeitpunkts t, zu dem jedes optische Signal von dem einen oder den mehreren Spannungs- und/oder Stromsensoren (103) empfangen wird;
Bestimmen einer Zeitverzögerung *tₛ*, die jedem Spannungs- und/oder Stromsensor (103) entspricht;
Bestimmen eines Zeitpunkts, zu dem jedes optische Signal von dem jeweiligen Spannungs- und/oder Stromsensor (103) ausgeht, durch Abziehen der jeweiligen Zeitverzögerung *tₛ* vom jeweiligen Zeitpunkt t, zu dem das Signal empfangen wird, und
Zeitstempeln des einen oder der mehreren optischen Signale oder der aus den optischen Signalen abgeleiteten Messungen mit den Zeitpunkten, zu denen die optischen Signale von jeweiligen Spannungs- und/oder Stromsensoren (103) ausgegangen sind.

## Revendications

1. Un procédé permettant d'effectuer une mesure de vecteur de phase synchrone consistant à :
recevoir, au niveau d'un interrogateur (131), un signal optique provenant d'un capteur de tension et/ou de courant (103) via une fibre optique (101) ;
**caractérisé par le fait que** le procédé consiste en outre à :
recevoir, au niveau de l'interrogateur (131), un signal de synchronisation temporelle (141) ;
déterminer, au niveau de l'interrogateur (131), l'heure *t* à laquelle le signal optique provenant du capteur de tension et/ou de courant (103) a été reçu ;
déterminer, au niveau de l'interrogateur (131), le retard de temps *ts* correspondant au capteur de tension et/ou de courant (103) ;
déterminer, au niveau de l'interrogateur (131), l'heure à laquelle le signal optique a été émis par le capteur de tension et/ou de courant (103) en déduisant le retard de temps *ts* de l'heure t à laquelle le signal optique a été reçu ;
calculer, au niveau de l'interrogateur (131), un vecteur de phase à partir du signal optique reçu ; et à
horodater le vecteur de phase avec l'heure à laquelle le signal optique a été émis par le capteur de tension et/ou de courant (103).

2. Le procédé de la revendication 1, dans lequel le retard de temps est déterminé en transmettant un signal au capteur de tension et/ou de courant (103), en recevant le signal une fois qu'il a été réfléchi par le capteur de tension et/ou de courant (103) et en déterminant un temps d'aller-retour *2tₛ* pour le signal.

3. Le procédé de la revendication 2, consistant à introduire une perturbation de l'amplitude d'une source lumineuse illuminant la fibre optique (101) et à détecter un effet de la perturbation sur la lumière réfléchie par le capteur de tension et/ou de courant (103).

4. Le procédé de l'une des revendications précédentes, dans lequel la fibre optique (101) est intégrée dans un câble d'alimentation.

5. Le procédé de l'une des revendications précédentes, dans lequel le calcul d'un vecteur de phase consiste à déterminer la tension et/ou le courant détecté à partir du signal optique reçu.

6. Le procédé de l'une des revendications précédentes, dans lequel le capteur de tension et/ou de courant (103) comprend un réseau de Bragg sur fibre (3) en contact avec un élément piézoélectrique (5) qui se dilate et se contracte en réponse à une tension et/ou à un courant détecté et dans lequel la tension et/ou le courant détecté est déterminé à partir de la position spectrale d'une longueur d'onde de réflexion de crête du réseau de Bragg sur fibre (3).

7. Le procédé de l'une des revendications précédentes, consistant à déterminer un retard de phase ϕ correspondant au retard de temps *ts*, et dans lequel le calcul du vecteur de phase à partir du signal optique reçu consiste à calculer un vecteur comprenant la magnitude et la phase de la tension et/ou du courant détecté, la phase de la tension et/ou du courant détecté étant décalée par le retard de phase ϕ.

8. Le procédé de l'une des revendications précédentes, consistant à recevoir plusieurs signaux optiques provenant de plusieurs capteurs de tension et/ou de courant (103) correspondants, à calculer plusieurs vecteurs de phase correspondants et à horodater chacun des vecteurs de phase.

9. Le procédé de la revendication 8, consistant à recevoir en continu des signaux optiques provenant de chaque capteur de tension et/ou de courant (103), à calculer en continu des vecteurs de phase à partir de chaque signal optique reçu et à horodater en continu chaque vecteur de phase.

10. Le procédé de la revendication 8 ou de la revendication 9, consistant à déterminer régulièrement un retard de temps et/ou un retard de phase correspondant à chaque capteur de tension et/ou de courant (103).

11. Le procédé de l'une des revendications précédentes, consistant en outre à émettre un ou plusieurs signaux de commande à un ou plusieurs endroits le long de la fibre optique et à recevoir au moins un signal de commande au niveau d'un module de commande (501, 601, 701, 801, 901).

12. Le procédé de la revendication 11, dans lequel le signal de commande est émis à un ou plusieurs endroits en réponse à l'analyse effectuée sur un ou plusieurs synchrophaseurs mesurés.

13. Le procédé de la revendication 11 ou de la revendication 12, dans lequel le ou les signaux de commande sont transmis à une longueur d'onde différente ou à des longueurs d'onde différentes du signal optique reçu provenant du capteur de tension et/ou de courant (103).

14. Le procédé de l'une des revendications 11 à 13, consistant à transmettre plusieurs signaux de commande à une longueur d'onde unique, à recevoir les différents signaux de commande au niveau du module de commande (501, 601) et à déterminer les signaux de commande destinés au module de commande (501, 601), et/ou à transmettre plusieurs signaux de commande à plusieurs longueurs d'onde, à recevoir plusieurs signaux de commande au niveau du module de commande (701, 801, 901) et à détecter un ou plusieurs signaux de commande transmis à une longueur d'onde unique propre au module de commande (701, 801, 901).

15. Un système de surveillance (121) permettant d'effectuer une mesure de vecteur de phase synchrone comprenant :
un interrogateur (131) en communication optique avec un ou plusieurs capteurs de tension et/ou de courant (103) via une fibre optique (101), **caractérisé par le fait que** l'interrogateur est configuré pour mettre en oeuvre le procédé de l'une des revendications précédentes.

16. Un procédé d'horodatage d'un signal provenant d'un capteur de tension et/ou de courant (103) consistant à :
recevoir, au niveau d'un interrogateur (131), un signal optique provenant du capteur de tension et/ou de courant (103) ;
**caractérisé par le fait que** le procédé consiste en outre à :
déterminer, au niveau de l'interrogateur (131), l'heure *t* à laquelle le signal optique provenant du capteur de tension et/ou de courant (103) est reçu ;
déterminer, au niveau de l'interrogateur (131), le retard de temps *tₛ* correspondant au capteur de tension et/ou de courant (103) ;
déterminer, au niveau de l'interrogateur (131), l'heure à laquelle le signal optique a été émis par le capteur de tension et/ou de courant (103) en déduisant le retard de temps *tₛ* de l'heure t à laquelle le signal optique est reçu ; et à
horodater le signal optique, ou une mesure dérivée du signal optique, avec l'heure à laquelle le signal optique a été émis par le capteur de tension et/ou de courant (103).

17. Un système de surveillance (121) comprenant :
un interrogateur (131) en communication optique avec un ou plusieurs capteurs de tension et/ou de courant (103) via une fibre optique (101), dans lequel l'interrogateur est configuré pour ;
recevoir un ou plusieurs signaux optiques provenant du ou des capteurs de tension et/ou de courant (103) ;
**caractérisé par le fait que** l'interrogateur est en outre configuré pour :
déterminer l'heure t à laquelle chaque signal optique provenant du ou des capteurs de tension et/ou de courant (103) est reçu ;
déterminer le retard de temps *tₛ* correspondant à chaque capteur de tension et/ou de courant (103) ;
déterminer l'heure à laquelle chaque signal optique a été émis par le capteur de tension et/ou de courant (103) respectif en déduisant le retard de temps *tₛ* respectif de l'heure t respective à laquelle le signal est reçu ; et à
horodater le ou les signaux optiques, ou les mesures dérivées des signaux optiques, avec les heures auxquelles les signaux optiques ont été émis par les capteurs de tension et/ou de courant (103) respectifs.
